# EUROPÄISCHE PATENTANMELDUNG

(11) **EP 2 160 084 A1**
(43) Veröffentlichungstag der Anmeldung: **03.03.2010**
(21) Anmeldenummer: 09168450.6
(22) Anmeldetag: 24.08.2009
(51) Int. Cl.: H05K 5/04, H05K 9/00, H05K 5/06

(54) **Kontaktanordnung**

(30) Priorität: 02.09.2008 DE 102008045649
(71) Anmelder: SIEMENS AKTIENGESELLSCHAFT, 80333 München (DE)
(72) Erfinder: Detterbeck, Manfred, 90530 Wendelstein (DE); Waedt, Günter, 91301 Forchheim (DE); Drews, Michael, 40591 Düsseldorf (DE); Fellechner, Lotar, 85253 Erdweg (DE); Gebhard, Bruno, 91301 Forchheim (DE); Kitzmüller, Andreas, 8010 Graz (AT); Polley, Rüdiger, 91058 Erlangen (DE); Summerer, Josef, 1100 Wien (AT); Zebunke, Stefan, 96199 Zapfendorf (DE)

(57) **Zusammenfassung**

Um eine Vorrichtung (1) zur Aufnahme elektrischer oder elektronischer Bauteile mit einem elektrisch leitenden und zumindest teilweise hohl ausgebildeten Aufnahmeabschnitt (2) und einem elektrisch leitenden Deckelabschnitt (3), der an dem Aufnahmeabschnitt (2) befestigbar ist, und einem Kontakt zum elektrischen Verbinden des Deckelabschnittes (3) mit dem Aufnahmeabschnitt (2), bereitzustellen, die einfach montierbar ist und eine sichere elektrische Verbindung zwischen Aufnahmeabschnitt (2) und Deckelabschnitt (3) ermöglicht, wird vorgeschlagen, dass der Kontakt ein fest mit dem Aufnahmeabschnitt (2) verbundenes Aufnahmekontaktstück (6) und ein fest mit dem Deckelabschnitt (3) verbundenes Deckelkontaktstück (5) aufweist, wobei Aufnahmekontaktstück (6) und Deckelkontaktstück (5) formkomplementär und so zueinander oder zu einem Verbindungsglied (12) ausgebildet sind, dass ausschließlich aufgrund der Befestigung des Deckelabschnittes (3) an dem Aufnahmeabschnitt (2) eine elektrische Verbindung zwischen Aufnahmeabschnitt (2) und Deckelabschnitt (3) bereitgestellt ist.

## Beschreibung

Die Erfindung betrifft eine Vorrichtung zur Aufnahme elektrischer oder elektronischer Bauteile mit einem elektrisch leitenden und zumindest teilweise hohl ausgebildeten Aufnahmeabschnitt und einem elektrisch leitenden Deckelabschnitt, der an dem Aufnahmeabschnitt befestigbar ist, und einem Kontakt zum elektrischen Verbinden des Deckelabschnittes mit dem Aufnahmeabschnitt.

Eine solche Vorrichtung ist aus dem Stand der Technik bereits bekannt. So sind zur Montage von elektrischen oder elektronischen Bauteilen, beispielsweise im Bereich des Schienenverkehrs, Montagekästen bekannt, die eine Montagebuchse als hohl ausgebildeten Aufnahmeabschnitt aufweisen, wobei ein Deckel zum Verschließen der Buchse dient. Die Buchse und der Deckel sind jeweils aus einem elektrisch leitenden Material gefertigt, wobei der Deckel angeschraubt oder lediglich durch einen Klemmsitz auf der Buchse/Vorrichtung gehalten ist. Zur wetterfesten Montage ist üblicherweise eine Dichtung zwischen der Aufnahmebuchse/Vorrichtung und dem Deckel vorgesehen, so dass das Eindringen von Wasser oder Schmutz in die Buchse/Vorrichtung vermieden wird. Die Dichtung bewirkt selbst bei elektrisch leitenden Dichtungen keine hinreichend niederimpedante Anbindung, so dass zu dessen sicheren elektrischen Verbindung gemäß dem Stand der Technik ein metallenes Verbindungsseil verwendet wird, das vor dem Aufsetzen des Deckels auf den Aufnahmeabschnitt von Hand montiert werden muss. Weiterhin ist es nachteilig, dass ein solches Verbindungsseil eingeklemmt werden oder selbst einen Kurzschluss im Inneren der Vorrichtung verursachen kann. Ferner stört es bei der Montage oder Reparatur der elektrischen oder elektronischen Bauteile.

Aufgabe der Erfindung ist es, eine Vorrichtung der eingangs genannten Art bereitzustellen, die ohne Montage von Verbindungsseilen eine sichere elektrische Verbindung zwischen Aufnahmeabschnitt und Deckelabschnitt ermöglicht.

Die Erfindung löst diese Aufgabe dadurch, dass der elektrische Kontakt ein fest mit dem Aufnahmeabschnitt verbundenes Aufnahmekontaktstück und ein fest mit dem Deckelabschnitt verbundenes Deckelkontaktstück aufweist, wobei Aufnahmekontaktstück und Deckelkontaktstück formkomplementär und so zueinander oder zu einem Verbindungsglied ausgebildet sind, dass ausschließlich aufgrund der Befestigung des Deckelabschnittes an dem Aufnahmeabschnitt ein dauerhaft sicherer elektrischer Kontakt zwischen Aufnahmeabschnitt und Deckelabschnitt bereitgestellt ist.

Erfindungsgemäß ist der Kontakt ständig mechanisch und dauerhaft elektrisch leitend mit den beiden Bauteilen der Vorrichtung, nämlich dem Aufnahme- und dem Deckelabschnitt, verbunden. Dabei weist der elektrische Kontakt zwei Kontaktstücke auf, die gemäß einer ersten Variante formkomplementär zueinander ausgebildet sind, so dass durch Aufbringen des Deckelabschnittes auf den Aufnahmeabschnitt beispielsweise unter Ineinanderfügen der Kontaktstücke ein zuverlässiger elektrischer Kontakt zwischen Deckelabschnitt und Aufnahmeabschnitt bereitgestellt ist. Alternativ hierzu sind die Kontaktstücke des elektrischen Kontaktes nicht zueinander sondern formkomplementär zu einem Verbindungsglied ausgebildet, das sich beispielsweise durch beide Kontaktstücke hindurch erstreckt. Das Verbindungsglied ist elektrisch leitend, so dass über das Verbindungsglied die Kontaktstücke elektrisch miteinander verbunden sind und so eine sichere elektrische Verbindung zwischen Deckelabschnitt und Aufnahmeabschnitt bereitgestellt ist.

Gemäß einer bevorzugten Ausgestaltung der Erfindung ist der Kontakt als Steckverbindung ausgestaltet und weist einen Kontaktstift, der fest und elektrisch leitend mit dem Deckelabschnitt verbunden ist, und eine Kontakthülse auf, die fest und elektrisch leitend mit dem Aufnahmeabschnitt verbunden ist oder umgekehrt. Durch diese Steckverbindung des Kontakts ist es möglich, den Deckelabschnitt einfach auf den Aufnahmeabschnitt aufzusetzen, wobei der Kontakt aufgrund seines Formschlusses neben der sicheren elektrischen Verbindung auch für eine Führung der beiden Bauteile zueinander sorgt, bis der gewünschte Sitz erzielt ist. Das Aufsetzen des Deckelabschnittes auf den Aufnahmeabschnitt erfolgt beispielsweise per Hand. Ob der Deckabschnitt oder der Aufnahmeabschnitt mit einem Kontaktstift ausgerüstet ist, kann von den jeweiligen Anforderungen abhängen.

Zweckmäßigerweise ist zwischen Deckelabschnitt und Aufnahmeabschnitt eine Dichtung angeordnet. Diese Vorrichtung ist jedoch in ihrer räumlichen Anordnung unabhängig von der Lage der Dichtung.

Grundsätzlich ist es im Rahmen der Erfindung beliebig, wie der Deckelabschnitt am Aufnahmeabschnitt gehalten ist. Gemäß einer Ausgestaltung ist der Deckelabschnitt beispielsweise mittels eines Klemmsitzes am Aufnahmeabschnitt gehalten. Der Vorteil bei einem Klemmsitz ist, dass durch einfaches Aufdrücken des Deckelabschnittes auf den Aufnahmeabschnitt per Hand eine sichere Halterung des Deckelabschnittes ermöglicht ist.

Die Montage ist daher ausgesprochen einfach und schnell. Entsprechendes gilt für Wartungsarbeiten. Hierzu lässt sich der Deckel ebenfalls per Hand leicht wieder aus dem Klemmsitz und somit vom Aufnahmeabschnitt entfernen.

Gemäß einer bevorzugten Ausgestaltung ist der Deckelabschnitt auf dem Aufnahmeabschnitt verschraubt. Dies ist insbesondere bei höheren Betriebsspannungen vorteilhaft.

Gemäß einer abweichenden Ausgestaltung sind Aufnahmekontaktstücke und Deckelkontaktstücke jeweils Teil eines Scharniers, das mittels Befestigungsabschnitten mechanisch und elektrisch mit dem Aufnahmeabschnitt beziehungsweise mit dem Deckelabschnitt verbunden ist, wobei die Befestigungsabschnitte elektrisch leitend an dem Aufnahmekontaktstück beziehungsweise an dem Deckelkontaktstück befestigt sind und über das Verbindungsglied elektrisch leitend miteinander verbunden sind. Gemäß dieser Ausgestaltung der Erfindung ist an Stelle eines Klemmsitzes eine drehbare, dauerhaft elektrisch leitende Verbindung zwischen Aufnahmeabschnitt und Deckelabschnitt bereitgestellt. Mit anderen Worten ist der Deckelabschnitt an dem Aufnahmeabschnitt elektrisch leitend angelenkt.

Gemäß einer Variante der Erfindung bilden das Aufnahmekontaktstück und das Deckelkontaktstück Kontaktbuchsen des Scharniers aus, wobei die Kontaktbuchsen drehbar auf einem gemeinsamen Kontaktstift als Verbindungsglied angeordnet sind, der die Kontaktbuchsen mechanisch und elektrisch leitend miteinander verbindet. Das Scharnier bildet hier ein Gelenk aus, das aus den ringförmigen Kontaktbuchsen besteht, die konzentrisch zueinander angeordnet und über einen Kontaktstift miteinander verbunden sind.

Weitere zweckmäßige Ausgestaltungen und Vorteile der Erfindung sind Gegenstand der nachfolgenden Beschreibung von Ausführungsbeispielen der Erfindung unter Bezug auf die Figuren der Zeichnung, wobei gleiche Bezugszeichen auf gleich wirkende Bauteile verweisen und wobei
- Figur 1: ein Ausführungsbeispiel der Vorrichtung zur Aufnahme elektrischer oder elektronischer Bauteile,
- Figur 2: eine Detailansicht der erfindungsgemäßen Vorrichtung in Ergänzung zu Figur 1,
- Figur 3: ein weiteres Ausführungsbeispiel der erfindungsgemäßen Vorrichtung,
- Figur 4: die Vorrichtung gemäß Figur 3 horizontal geschnitten,
- Figur 5: eine Schnittansicht der Vorrichtung gemäß Figur 3 vertikal geschnitten und
- Figur 6: ein weiteres Ausführungsbeispiel mit fliegendem Verbindungsstück zeigen.

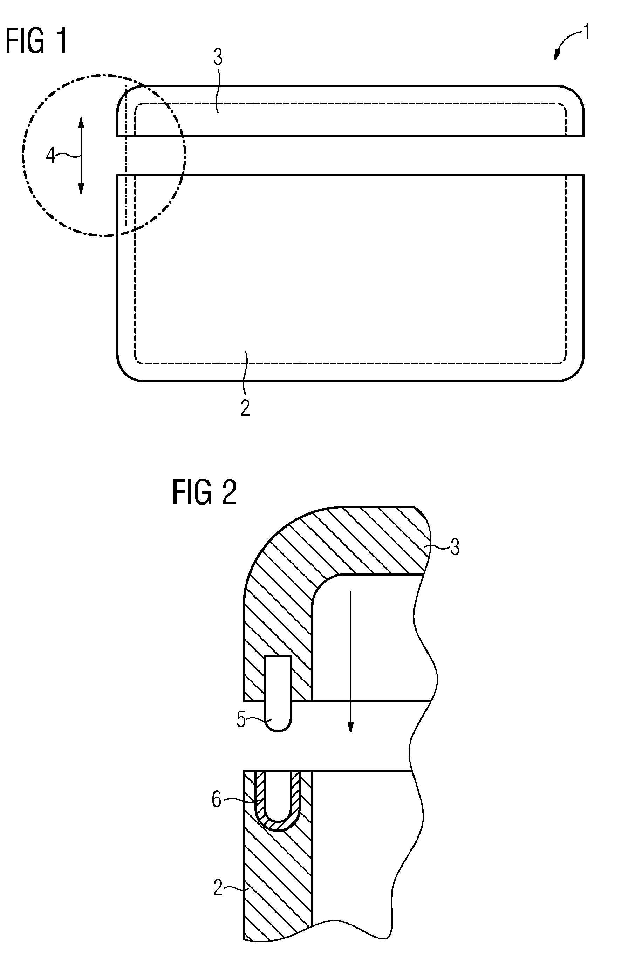

Figur 1 zeigt ein Ausführungsbeispiel der erfindungsgemäßen Vorrichtung 1, die einen Aufnahmeabschnitt 2 sowie einen Deckelabschnitt 3 aufweist. Der Aufnahmeabschnitt 2 ist innen hohl ausgebildet und dient zur Aufnahme von elektrischen oder elektronischen Bauteilen, die beispielsweise im Bereich des Schienenverkehrs zum Einsatz gelangen. Der Aufnahmeabschnitt 2 ist über in Figur 1 figürlich nicht dargestellte Befestigungsmittel, beispielsweise in einer Lokomotive, angebracht.

Wie in Figur 1 durch den Doppelpfeil 4 angedeutet ist, wird der Deckelabschnitt 3 an dem Aufnahmeabschnitt 2 gehalten, beispielsweise mittels einer figürlich nicht dargestellten Schraubverbindung. Der Deckelabschnitt 3 ist somit einfach an dem Aufnahmeabschnitt 2 befestigbar. Dabei sind Deckelabschnitt 3 und Aufnahmeabschnitt 2 aus einem elektrisch leitenden Material, in diesem Fall aus einem geeigneten metallischen Material, hergestellt. Dabei sind Aufnahmeabschnitt 2 und Deckelabschnitt 3 beispielsweise mit einem Lack- oder sonstigen Überzug versehen.

Figur 2 zeigt den in Figur 1 durch einen gestrichelten Kreis dargestellten Teilbereich in einer vergrößerten Darstellung, wobei der Aufnahmeabschnitt 2 sowie der Deckelabschnitt 3 in einer seitlich geschnittenen Darstellung gezeigt sind. Es ist erkennbar, dass der Deckelabschnitt 3 ein Deckelkontaktstück 5 in Gestalt eines Kontaktstiftes aufweist, der mit seinem einen Ende fest in dem Deckelabschnitt 3 mechanisch und elektrisch leitend eingebunden ist. Der Kontaktstift 5 an dem Deckelabschnitt 3 ist formkomplementär zu einem Aufnahmekontaktstück 6 ausgestaltet, das als Kontakthülse in dem Aufnahmeabschnitt 2 ausgestaltet ist und mit diesem elektrisch leitend verbunden ist. Beim Aufsetzen des Deckelabschnitts 3 auf den Aufnahmeabschnitt 2 kommt es zum Klemmsitz und somit zum elektrischen Kontakt zwischen dem Deckelkontaktstück 5 sowie dem Aufnahmekontaktstück 6. Der Deckelabschnitt 3 ist somit mit den Aufnahmeabschnitt 2 dauerhaft elektrisch leitend verbunden.

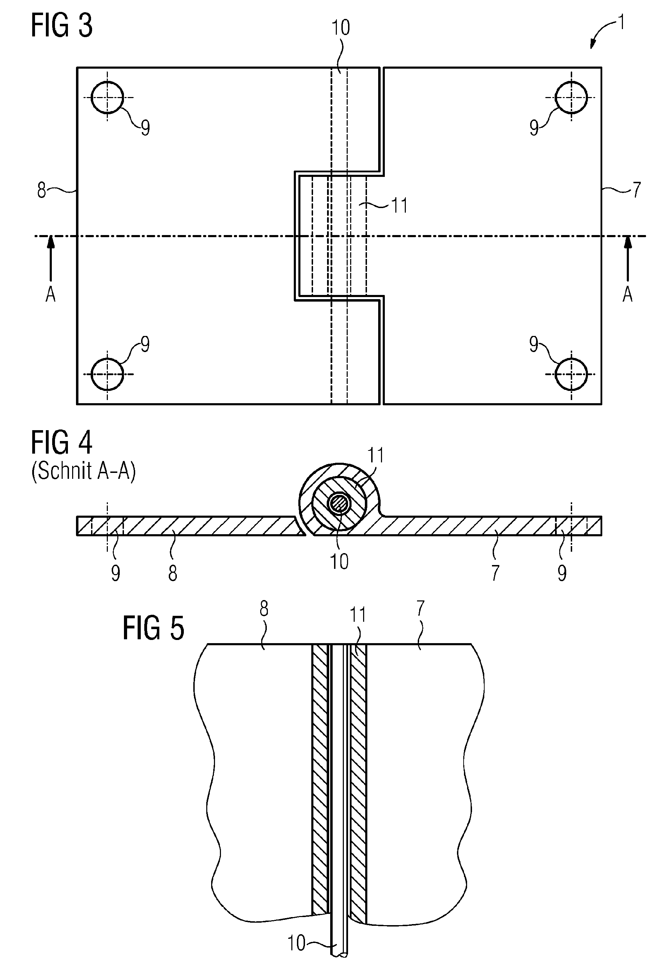

Figur 3 zeigt ein weiteres Ausführungsbeispiel der erfindungsgemäßen Vorrichtung 1, die hier als Scharnier ausgebildet ist. Das Scharnier 1 umfasst einen ersten Befestigungsabschnitt 7, der fest mit dem Deckelabschnitt 3 verbindbar ist.

Darüber hinaus ist ein zweiter Befestigungsabschnitt 8 vorgesehen, der fest mit dem Aufnahmeabschnitt 2 verbunden ist. Die Befestigung erfolgt beispielsweise über eine Schraubverbindung, wobei Schrauben jeweils durch eine der Durchgangsöffnungen 9 in dem Deckelabschnitt 3 beziehungsweise Aufnahmeabschnitt 2 eingeschraubt werden. Die aufeinander zuweisenden Seiten der Befestigungsabschnitte 7, 8 bilden eine Gelenkverbindung zwischen diesen Bauteilen aus. Hierzu ist ein Scharnierbolzen 10 fest, beispielsweise durch Presssitz, mit dem Befestigungsabschnitt 8 verbunden. Der Befestigungsabschnitt 7 weist hingegen die Gestalt einer Aufnahmebohrung für die Kontaktbuchse 11 auf, wobei der Scharnierbolzen 10 die Kontaktbuchse 11 des Befestigungsabschnitts 7 durchgreift. Dabei sind der Außendurchmesser des Scharnierbolzens 10 und der Innendurchmesser der Kontaktbuchse 11 so aufeinander abgestimmt, dass trotz der drehbaren Halterung des Scharnierbolzens 10 in der Kontaktbuchse 11 eine fortwährende elektrische Verbindung zwischen den Befestigungsabschnitten 7,8 bereitgestellt ist.

Figur 4 zeigt das Scharnier 1 gemäß Figur 3 in einer in der Mitte von Figur 3 quer geschnittenen Ansicht. Es ist erkennbar, dass der Befestigungsabschnitt 7 die Kontaktbuchse 11 aufnimmt, wobei der Presssitz des Scharnierbolzens 10 am Befestigungsabschnitt 8 auf Grund der Kontaktbuchse 11 verdeckt gezeigt ist. In dieser Ansicht ist die Bemessung der Bauteile nur schematisch angedeutet. Wesentlich ist, dass die Befestigungsabschnitte 7 und 8 über den Scharnierbolzen 10 und die Kontaktbuchse 11 dauerhaft elektrisch leitend miteinander verbunden sind. Der Scharnierbolzen 10 dient somit als Verbindungsglied. Dabei umfasst die Kontaktbuchse 11 ein gestrichelt gezeichnetes Einpressteil, das in eine Bohrung des Befestigungsabschnittes 7 eingepresst ist.

Figur 5 zeigt das Scharnier gemäß den Figuren 3 oder 4 in einer geschnittenen Teildarstellung. Auch hier ist erkennbar, dass sich der Scharnierbolzen 10 durch die Kontaktbuchse 11 des Befestigungsabschnitts 7 erstreckt.

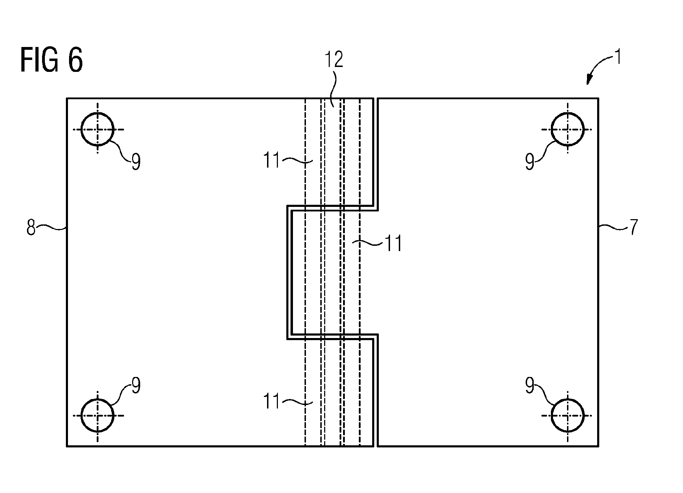

Figur 6 zeigt ein weiteres Ausführungsbeispiel der erfindungsgemäßen Vorrichtung 1, die wieder als Scharnier ausgebildet ist. Im Gegensatz zu dem in Figur 3 gezeigten Ausführungsbeispiel der Erfindung ist der Scharnierbolzen 10 gemäß Figur 6 nicht durch einen Presssitz mit dem Befestigungsabschnitt 8 verbunden. Vielmehr bildet in dem in Figur 6 gezeigten Ausführungsbeispiel auch der Befestigungsabschnitt 8 eine Kontaktbuchse 11 aus, in welcher der Scharnierbolzen 10 entweder fest oder ebenfalls unter Ausbildung eines permanenten dauerhaften elektrischen Kontaktes drehbar gehalten ist.

## Patentansprüche

1. Vorrichtung (1) zur Aufnahme elektrischer oder elektronischer Bauteile mit einem elektrisch leitenden und zumindest teilweise hohl ausgebildeten Aufnahmeabschnitt (2) und einem elektrisch leitenden Deckelabschnitt (3), der an dem Aufnahmeabschnitt (2) befestigbar ist, und einem elektrisch leitenden Kontakt zum Verbinden des Deckelabschnittes (3) mit dem Aufnahmeabschnitt (2),
**dadurch gekennzeichnet, dass**
der Kontakt ein fest mit dem Aufnahmeabschnitt (2) verbundenes Aufnahmekontaktstück (6) und ein fest mit dem Deckelabschnitt (3) verbundenes Deckelkontaktstück (5) aufweist, wobei Aufnahmekontaktstück (6) und Deckelkontaktstück (5) formkomplementär und so zueinander oder zu einem Verbindungsglied (10) ausgebildet sind, dass ausschließlich aufgrund der Befestigung des Deckelabschnittes (3) an dem Aufnahmeabschnitt (2) ein elektrischer Kontakt zwischen Aufnahmeabschnitt (2) und Deckelabschnitt (3) bereitgestellt ist.

2. Vorrichtung (1) nach Anspruch 1,
**dadurch gekennzeichnet, dass**
der Kontakt als Steckverbindung ausgebildet ist und einen Kontaktstift (5) sowie eine Kontakthülse (6) aufweist.

3. Vorrichtung (1) nach Anspruch 2,
**gekennzeichnet durch**
eine zwischen Deckelabschnitt (3) und Aufnahmeabschnitt (2) angeordnete Dichtung.

4. Vorrichtung (1) nach einem der vorhergehenden Ansprüche,
**dadurch gekennzeichnet, dass**
der Deckelabschnitt (3) ausschließlich mittels eines Klemmsitzes am Aufnahmeabschnitt (2) gehalten ist.

5. Vorrichtung (1) nach Anspruch 1,
**dadurch gekennzeichnet, dass**
Aufnahmekontaktstück (6) und Deckelkontaktstück (5) jeweils Teil eines Scharniers sind, das mittels Befestigungsabschnitten (7,8) mechanisch und elektrisch mit dem Aufnahmeabschnitt (2) beziehungsweise mit dem Deckelabschnitt (3) verbunden ist, wobei die Befestigungsabschnitte (7,8) elektrisch leitend mit dem Aufnahmekontaktstück (6) beziehungsweise mit dem Deckelkontaktstück (5) und über das Verbindungsglied (12) elektrisch leitend miteinander verbunden sind.

6. Vorrichtung (1) nach Anspruch 5,
**dadurch gekennzeichnet, dass**
Aufnahmekontaktstück (5) und/oder Deckelkontaktstück (6) Kontaktbuchsen (11) des Scharniers ausbilden, wobei jede Kontaktbuchse (11) auf einem gemeinsamen Scharnierbolzen (10)als Verbindungsglied angeordnet ist, der die Befestigungsabschnitte (7,8) mechanisch und elektrisch leitend miteinander verbindet.
